# EUROPEAN PATENT SPECIFICATION

(11) **EP 4 432 509 B1**
(45) Date of publication and mention of the grant of the patent: **11.03.2026**
(21) Application number: 21963172.8
(22) Date of filing: 08.11.2021
(51) Int. Cl.: H02J 7/00, H02J 7/02, B60L 53/65

(54) **CHARGING/DISCHARGING CONTROL METHOD AND CHARGING/DISCHARGING CONTROL DEVICE**
LADE-/ENTLADESTEUERUNGSVERFAHREN UND LADE-/ENTLADESTEUERUNGSVORRICHTUNG
PROCÉDÉ DE COMMANDE DE CHARGE/DÉCHARGE ET DISPOSITIF DE COMMANDE DE CHARGE/DÉCHARGE

(43) Date of publication of application: 18.09.2024
(73) Proprietor: NISSAN MOTOR CO., LTD., Yokohama-shi, Kanagawa 221-0023 (JP); RENAULT S.A.S., 92100 Boulogne-Billancourt (FR)
(72) Inventor: MURAI, Kensuke, Atsugi-shi, Kanagawa 243-0123 (JP); SUZUKI, Kenta, Atsugi-shi, Kanagawa 243-0123 (JP)
(74) Representative: Hoefer & Partner Patentanwälte mbB
(86) International application number: PCT/IB2021/000763
(87) International publication number: WO 2023/079327

(56) References cited:
- JP-A- 2011 223 657
- JP-A- 2011 223 657
- JP-A- 2015 065 792
- JP-A- 2015 065 792
- JP-A- 2015 100 173
- JP-A- 2015 100 173
- JP-A- 2020 124 061
- US-B2- 9 649 947

## Description

### TECHNICAL FIELD

The present invention relates to a charging/discharging control method and a charging/discharging control device.

### BACKGROUND ART

An invention in which in a power system including a plurality of power conditioners (power modules) and a central management device which manages the plurality of power conditioners, a control unit included in each power conditioner calculates an individual target power of the power conditioner based on a signal transmitted from the central management device and controls an individual output power of the power conditioner such that the individual output power becomes equal to the individual target power has been known (Patent Literature 1).

### CITATION LIST

### PATENT LITERATURE

Patent Literature 1: International Publication No. WO2017/150376

### SUMMARY OF INVENTION

### PROBLEMS TO BE SOLVED BY INVENTION

According to the invention described in Patent Literature 1, since a signal from the central management device is transmitted through wireless communications, in a case where different power systems are adjacent to each other, there is a possibility that the control unit included in the power conditioner receives signals from a plurality of central management devices. In this case, there is a problem that it is necessary for the user to designate a signal that has to be followed in a charging/discharging control of the power conditioner from among a plurality of signals, thus increasing works until the start of the charging/discharging control of the power conditioner.

The present invention has been made in view of the above-described problem. An object of the present invention is to provide a charging/discharging control method and a charging/discharging control device that are capable of specifying a signal that has to be followed in a charging/discharging control of a power module without designation from a user and starting the charging/discharging control of the power module even in a case where a receiver included in the power module receives signals from a plurality of power systems.

### SOLUTION TO SOLVE PROBLEMS

A charging/discharging control method and a charging/discharging control device in accordance with an embodiment of the present invention, when controlling a power module connected to any of a plurality of power systems, receive a signal broadcast for each of the power systems via a receiver included in the power module. The method and the device then calculate a degree of relationship between the acquired signal and an input voltage inputted to the power module for each of the power systems, and control the power module based on the signal relating to the power system having the degree of relationship greater than or equal to a prescribed threshold.

### EFFECTS OF INVENTION

The present invention makes it possible to specify a signal that has to be followed in a charging/discharging control of a power module without designation from a user and to start the charging/discharging control of the power module even in a case where a receiver included in the power module receives signals from a plurality of power systems.

### BRIEF DESCRIPTION OF DRAWINGS

[Fig. 1] Fig. 1 is a schematic diagram showing a configuration of a power system according to one embodiment of the present invention.
[Fig. 2] Fig. 2 is a block diagram showing a configuration of a charging/discharging control device included in the power system according to the one embodiment of the present invention.
[Fig. 3] Fig. 3 is a flowchart showing processing of a charging/discharging control in the power system according to the one embodiment of the present invention.

### DESCRIPTION OF EMBODIMENTS

Hereinafter, embodiments according to the present invention will be described with reference to the drawings. In the description of the drawings, the same parts are denoted by the same reference signs, and description of these will be omitted.

### (Configuration of Power System)

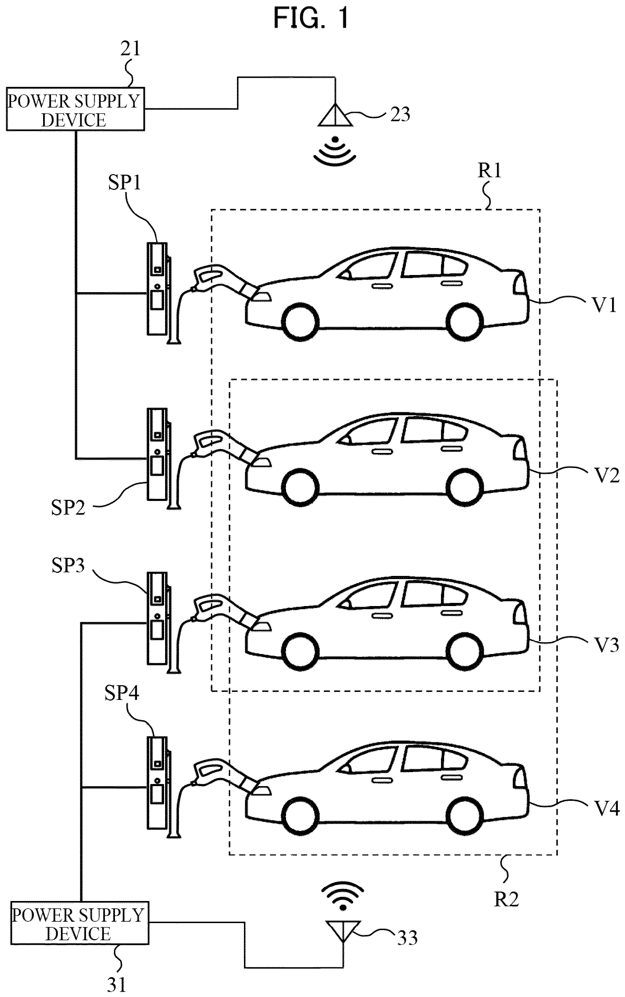

An example of a configuration of a power system according to the present embodiment will be described with reference to Fig. 1. Fig. 1 shows vehicles V1, V2, V3, and V4. The vehicles V1, V2, V3, and V4 each include a power module 50 and a charging/discharging control device 10 as described later. For example, the power module 50 is an on-board rechargeable battery. The power module 50 and the charging/discharging control device 10 are not limited to those to be mounted on vehicles, but otherwise may be those mounted on mobile bodies (aircraft, drones, and the like).

In addition, Fig. 1 shows a power supply device 21 which supplies power to charging spots SP1 and SP2, and a transmitter 23 which conducts broadcasting to the vehicles V1, V2, and V3 located in an area R1 through wireless communications. The power modules 50 mounted on the vehicles V1 and V2 are supplied with power from the power supply device 21 via the charging spots SP1 and SP2, respectively. The power supply device 21, the transmitter 23, the charging spots SP1 and SP2, and the vehicles V1 and V2 constitute a first power system.

Moreover, Fig. 1 shows a power supply device 31 which supplies power to charging spots SP3 and SP4, and a transmitter 33 which conducts broadcasting to the vehicles V2, V3, and V4 located in an area R2 through wireless communications. The power modules 50 mounted on the vehicles V3 and V4 are supplied with power from the power supply device 31 via the charging spots SP3 and SP4, respectively. The power supply device 31, the transmitter 33, the charging spots SP3 and SP4, and the vehicles V3 and V4 constitute a second power system.

Not limited to the example shown in Fig. 1, the number of charging spots connected to the power supply device 21 or 31 may be one or may be two or more. In addition, the number of vehicles which are supplied with power from the power supply device 21 or 31 may be one or may be two or more. Besides, the number of power systems may be two or more.

It should be noted that in Fig. 1, the vehicles V2 and V3 located on both of the area R1 and the area R2 can receive a first signal from the transmitter 23 through broadcasting and can receive a second signal from the transmitter 33 through broadcasting. The first signal is a signal relating to the first power system and is a signal for adjusting supply power in the first power system. The second signal is a signal relating to the second power system and is a signal for adjusting supply power in the second power system.

At a time point when the vehicle V2 and the vehicle V3 are connected respectively to the charging spot SP2 and the charging spot SP3 to start charging, which signal of the first signal and the second signal the control of the power module 50 mounted on the vehicle V2 or V3 has to be based on is unclear. On the other hand, it can be seen that the power module 50 mounted on the vehicle V2 or V3 is connected to either one of the first power system and the second power system based on the fact that the vehicle V2 or V3 can receive both first signal and second signal.

If the user were to specify which signal the control of the power module 50 has to be based on, a problem would occur that works until the start of the charging/discharging control of the power module 50 increase, which is cumbersome to the user. In addition, if which signal the control of the power module 50 has to be based on were specified through communications between the charging spot SP2 and the vehicle V2 or communications between the charging spot SP3 and the vehicle V3, it would be necessary to provide a facility for communications between charging spots and vehicles, which causes a problem that the cost increases. As described later, the charging/discharging control device 10 which controls the power module 50 can solve these problems.

### (Configuration of Charging/discharging Control Device)

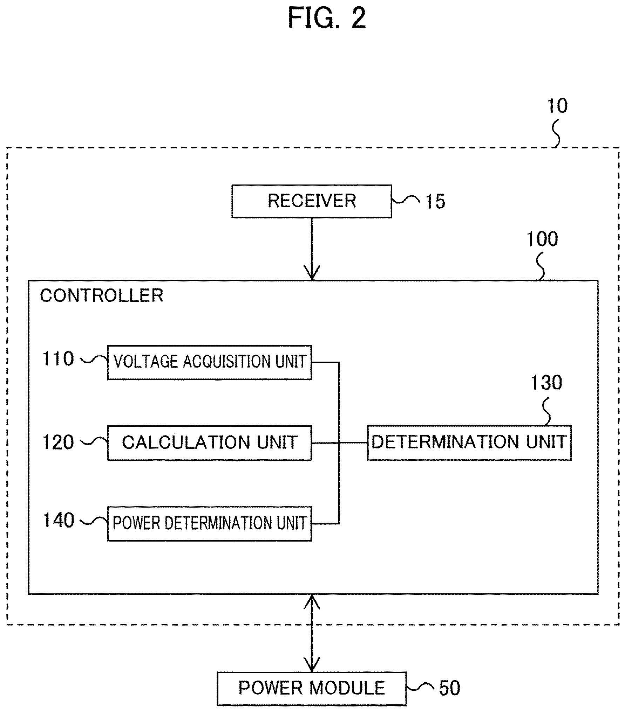

Fig. 2 is a block diagram showing a configuration of the charging/discharging control device included in the power system according to the present embodiment. As shown in Fig. 2, the charging/discharging control device 10 includes a receiver 15 and a controller 100. In addition, the controller 100 is connected to the power module 50.

The receiver 15 receives a signal broadcast from the transmitter (the transmitter 23 or 33 in Fig. 1) included in the power system through wireless communications. For example, the receiver 15 may receive signals transmitted from the transmitter by means of a radio wave such as a low-frequency wave or an ultra-high frequency wave or may receive signals transmitted from the transmitter by means of an infrared ray. Besides, the receiver 15 may receive signals transmitted from the transmitter by utilizing a mobile communication function such as 4G/LTE or 5G.

The receiver 15 receives a signal broadcast for each power system. The receiver 15 may receive the signal at at least two or more time points for each power system. A larger number of time points at which signals are acquired by the receiver 15 for each power system allow the precision of calculation of a degree of relationship, which will be described later, to be improved. Note that the receiver 15 may receive the signal during a duration time greater than or equal to a prescribed time period for each power system.

The controller 100 is a general-purpose computer including a CPU (Central Processing Unit), a memory, a storage device, an input-output unit, and the like.

In the controller 100, a computer program (charging/discharging control program) for allowing the controller 100 to function as the charging/discharging control device 10 is installed. By executing the computer program, the controller 100 functions as a plurality of information processing circuits included in the charging/discharging control device 10.

Note that although an example of achieving the plurality of information processing circuits included in the charging/discharging control device 10 by means of software is shown here, it is of course also possible to configure the information processing circuits by preparing hardware dedicated to executing each information processing shown below. In addition, the plurality of information processing circuits may be configured by means of individual hardware.

The controller 100 includes a voltage acquisition unit 110, a calculation unit 120, a determination unit 130, and a power determination unit 140.

The voltage acquisition unit 110 acquires an input voltage of power inputted from the power system to the power module 50. Note that the voltage acquisition unit 110 may acquire an input voltage at at least two or more time points for each power system while the receiver 15 is receiving signals broadcast for each power system. In addition, the voltage acquisition unit 110 may acquire an input voltage during a duration time greater than or equal to a prescribed time period for each power system.

The calculation unit 120 calculates a degree of relationship between a signal (signal to be evaluated) received via the receiver 15 and an input voltage acquired by the voltage acquisition unit 110 for each power system. Note that the calculation unit 120 may use a signal having an intensity greater than or equal to a prescribed intensity as a signal to be evaluated and calculate the degree of relationship based on the signal to be evaluated.

More specifically, the calculation unit 120 calculates a predicted amount of change in the power of the power module 50 based on a signal. In addition, the calculation unit 120 calculates an amount of change in the input voltage. Then, the calculation unit 120 calculates the degree of relationship between the signal and the input voltage based on the calculated predicted amount of change in the power and the calculated amount of change in the input voltage.

For example, there is a relation that as the charged power in the entire power module connected to a power system increases, the input voltage of the power module decreases, while as the charged power in the entire power module connected to the power system decreases, the input voltage of the power module increases. That is, the predicted amount of change in the power of the power module 50, which is calculated based on a signal for adjusting the supply power in the power system, and the amount of change in the input voltage are in a negative correlation.

Hence, the calculation unit 120 calculates the degree of relationship such that the degree of relationship calculated in a case where the calculated predicted amount of change in the power and the calculated amount of change in the input voltage have opposite signs becomes larger than the degree of relationship calculated in a case where the calculated predicted amount of change in the power and the calculated amount of change in the input voltage have the same sign.

In addition, the calculation unit 120 may calculate a ratio of the calculated amount of change in the input voltage to the calculated predicted amount of change in the power and calculate, for a signal having smaller dispersion of the calculated ratio, a larger degree of relationship for the signal. Note that to improve the precision of the dispersion of the ratio to be calculated, the aforementioned voltage acquisition unit 110 may acquire input voltages at at least three or more time points for each power system. With a larger number of time points at which to acquire input voltages, the precision of the dispersion of the ratio to be calculated is improved.

Besides, in the case where there are a plurality of signals for which the calculated degrees of relationship are equal, the calculation unit 120 may recalculate the degree of relationship based on a plurality of signals acquired after the power of the power module 50 is changed by a prescribed amount. For explanation, a signal relating to a first power system is called a first signal, and a signal relating to a second power system different from the first power system is called a second signal. Here, in a case where a degree of relationship calculated based on the first signal and a degree of relationship calculated based on the second signal are equal, the calculation unit 120 may recalculate the degree of relationship based on the first signal and the second signal acquired after the power of the power module 50 is changed by a prescribed amount.

The reason why the power of the power module 50 is changed by a prescribed amount in the above description is for measuring a response of the power system to the change in the power of the power module 50. A variation can occur in a signal for adjusting the supply power in the power system to which the power module 50 the power of which has been changed is connected. Hence, it is expected that for a signal in which a variation has occurred among a plurality of signals acquired after the power of the power module 50 is changed, the degree of relationship after the recalculation becomes large. Hence, it becomes easy to specify a signal that has to be used in controlling the power module 50 by recalculating the degree of relationship.

The determination unit 130 determines whether or not the receiver 15 has received a plurality of signals. In addition, the determination unit 130 determines whether or not the degree of relationship has been calculated by the calculation unit 120 for all signals to be evaluated among the plurality of signals received by the receiver 15.

Moreover, the determination unit 130 selects a signal to be used in controlling the power module 50 based on degrees of relationship from among a plurality of signals broadcast for each power system. More specifically, the determination unit 130 selects a signal having the degree of relationship greater than or equal to a prescribed threshold. In addition, the determination unit 130 may select a signal having the highest degree of relationship from among a plurality of signals broadcast for each power system. The number of signals to be selected by the determination unit 130 may be one or more.

The power determination unit 140 controls the power module 50 based on a signal selected by the determination unit 130.

Note that in the case where there are a plurality of signals selected by the determination unit 130, the power determination unit 140 may determine the amount of change in the power of the power module 50 based on the plurality of signals thus selected.

For explanation, a signal relating to a first power system is called a first signal, and a signal relating to a second power system different from the first power system is called a second signal. In addition, an absolute value of a predicted amount of increase in the power of the power module based on the first signal is called a first amount of increase, and an absolute value of a predicted amount of increase in the power of the power module based on the second signal is called a second amount of increase. The power determination unit 140 may determine a smaller amount of the first amount of increase and the second amount of increase as the amount of increase in the power of the power module 50. In the case of increasing the power of the power module 50, the reason why to select a smaller amount of the amounts of increase in the power calculated based on a plurality of signal includes stabilizing an operation of the entire power system, for example.

In addition, an absolute value of a predicted amount of decrease in the power of the power module based on the first signal is called a first amount of decrease, and an absolute value of a predicted amount of decrease in the power of the power module based on the second signal is called a second amount of decrease. The power determination unit 140 may determine a larger amount of the first amount of decrease and the second amount of decrease as the amount of decrease in the power of the power module 50. In the case of decreasing the power of the power module 50, the reason why to select a larger amount of the amounts of decrease in the power calculated based on a plurality of signals includes stabilizing the operation of the entire power system, for example.

### (Procedure of Processing of Charging/Discharging Control)

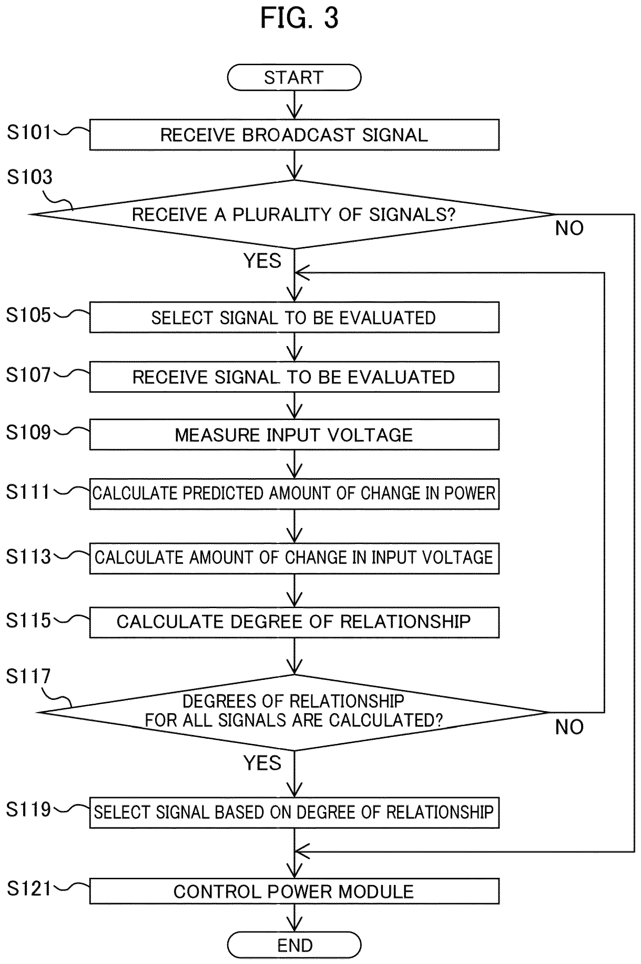

Next, a procedure of processing of the charging/discharging control according to the present embodiment will be described with reference to a flowchart of Fig. 3. The processing shown in the flowchart of Fig. 3 may be repeatedly executed while charging is conducted by connecting the power module 50 to the power system. In addition, the processing shown in the flowchart of Fig. 3 may be repeatedly executed during a prescribed time period after the power module 50 is connected to the power system.

In step S101, the receiver 15 receives a signal broadcast from the transmitter included in the power system through wireless communications.

In step S103, the determination unit 130 determines whether or not the receiver 15 has received a plurality of signals.

If it is determined that the receiver 15 has not received a plurality of signals (NO in step S103), the processing proceeds to step S121.

If it is determined that the receiver 15 has received a plurality of signals (YES in step S103), the processing proceeds to step S105, and the calculation unit 120 selects a signal to be evaluated from among the plurality of signals thus received in order to evaluate the degree of relationship. For example, the controller 100 may set the receiver 15 in order to receive a signal to be evaluated.

In step S107, the receiver 15 receives a signal to be evaluated.

In step S109, the voltage acquisition unit 110 acquires an input voltage of the power to be inputted from the power system to the power module 50.

In step S111, the calculation unit 120 calculates a predicted amount of change in the power of the power module 50 based on the signal.

In step S113, the calculation unit 120 calculates an amount of change in the input voltage.

In step S115, the calculation unit 120 calculates a degree of relationship between the signal and the input voltage based on the calculated predicted amount of change in the power and the calculated amount of change in the input voltage.

In step S117, the determination unit 130 determines whether or not the degree of relationship has been calculated for all signals to be evaluated among the plurality of signals received by the receiver 15.

If it is determined that the degree of relationship has not been calculated for all the signals (NO in step S117), the processing proceeds to step S105.

If it is determined that the degree of relationship has been calculated for all the signals (YES in step S117), the processing proceeds to step S119, and the determination unit 130 selects a signal to be used in controlling the power module 50, based on the degree of relationship, from among a plurality of signals broadcast for each power system.

In step S121, the power determination unit 140 controls the power module 50 based on the signal selected by the determination unit 130. Note that in the case where only one signal has been received by the receiver 15, the power determination unit 140 controls the power module 50 based on that received signal. Thereafter, the processing shown in the flowchart of Fig. 3 is ended.

### (Advantageous Effects of Embodiments)

As described above in detail, when controlling a power module connected to any of a plurality of power systems, the charging/discharging control method and the charging/discharging control device according to the present embodiment receive a signal broadcast for each of the power systems via a receiver included in the power module and acquire an input voltage inputted to the power module. The charging/discharging control method and the charging/discharging control device then calculate a degree of relationship between the signal and the input voltage for each power system and control the power module based on the signal relating to the power system having the degree of relationship greater than or equal to a prescribed threshold.

This makes it possible to specify a signal that has to be followed in a charging/discharging control of a power module without designation from a user and start the charging/discharging control of the power module even in a case where a receiver included in the power module receives signals from a plurality of power systems.

Moreover, it is unnecessary to provide a facility that communicates with a controller for controlling a power module in a charging spot which is supplied with power of a power system. As a result, it is possible to suppress an increase in cost.

In addition, the charging/discharging control method and the charging/discharging control device according to the present embodiment may be such that the signal is received at at least two or more time points for each power system. This makes it possible to surely calculate the degree of relationship between the signal and the input voltage. In addition, since with a larger number of time points at which signals are received, the precision of the degree of relationship to be calculated is improved, and it is thus possible to specify a signal that has to be followed in a charging/discharging control of a power module with high precision.

Moreover, the charging/discharging control method and the charging/discharging control device according to the present embodiment may be such that the signal is received for a prescribed time period or more for each power system. This makes it possible to surely calculate the degree of relationship between the signal and the input voltage. In addition, as the signal is received for a prescribed time period or more, the number of time points at which the signals are received increases, and the precision of the degree of relationship to be calculated is improved. Thus, it is possible to specify a signal that has to be followed in a charging/discharging control of a power module with high precision.

In addition, the charging/discharging control method and the charging/discharging control device according to the present embodiment may be such that the degree of relationship calculated based on the signal in a case where a predicted amount of change in the power of the power module and an amount of change in the input voltage have opposite signs is calculated to become larger than the degree of relationship calculated based on the signal in a case where the amount of change and the amount of change in the input voltage have the same sign.

There is a relation that as the charged power in the entire power module connected to a power system increases, the input voltage of the power module decreases, while as the charged power in the entire power module connected to the power system decreases, the input voltage of the power module increases. The above-described configuration makes it possible to reflect the relation between the charged power in the entire power module and the input voltage in the calculation of the degree of relationship. Therefore, it is possible to improve the precision of the degree of relationship.

Moreover, the charging/discharging control method and the charging/discharging control device according to the present embodiment may be such that when the signal relating to a first power system is called a first signal, and the signal relating to a second power system different from the first power system is called a second signal, in a case where a degree of relationship calculated based on the first signal and a degree of relationship calculated based on the second signal are equal, the degree of relationship is recalculated based on the first signal and the second signal acquired after the power of the power module is changed.

A variation can occur in a signal for adjusting supply power in a power system to which a power module the power of which has been changed is connected. Hence, it is expected that for a signal in which a variation has occurred among a plurality of signals acquired after power of a power module is changed, the degree of relationship after the recalculation becomes large. It becomes easy to specify a signal that has to be used in controlling a power module by recalculating the degree of relationship. By changing the power of the power module by a prescribed amount, it is possible to measure a response of the power system to the change in the power of the power module, and it is thus possible to specify a signal that has to be followed in a charging/discharging control of a power module with high precision.

In addition, the charging/discharging control method and the charging/discharging control device according to the present embodiment may be such that when the signal relating to a first power system is called a first signal, the signal relating to a second power system different from the first power system is called a second signal, an absolute value of a predicted amount of increase in the power of the power module based on the first signal is called a first amount of increase, and an absolute value of a predicted amount of increase in the power of the power module based on the second signal is called a second amount of increase, a control of increasing the power of the power module by a smaller amount of the first amount of increase and the second amount of increase is conducted. This makes it possible to stabilize an operation of the entire power system. In addition, it is possible to reduce an influence on charging/discharging of another power module connected to the power system.

Moreover, the charging/discharging control method and the charging/discharging control device according to the present embodiment may be such that when the signal relating to a first power system is called a first signal, the signal relating to a second power system different from the first power system is called a second signal, an absolute value of a predicted amount of decrease in the power of the power module based on the first signal is called a first amount of decrease, and an absolute value of a predicted amount of decrease in the power of the power module based on the second signal is called a second amount of decrease, a control of decreasing the power of the power module by a larger amount of the first amount of decrease and the second amount of decrease. This makes it possible to stabilize an operation of the entire power system. In addition, it is possible to reduce an influence on charging and discharging of another power module connected to the power system.

In addition, the charging/discharging control method and the charging/discharging control device according to the present embodiment may be such that the degree of relationship is calculated based on the signal having an intensity greater than or equal to a prescribed intensity. This makes it possible to calculate the degree of relationship by narrowing down a plurality of received signals to a signal to be evaluated. As a result, it is possible to reduce a calculation load. Furthermore, time taken to specify a signal that has to be followed in a charging/discharging control of a power module is shortened, and it is thus possible to shorten time until the start of the charging/discharging control.

Moreover, the charging/discharging control method and the charging/discharging control device according to the present embodiment may be such that the signal is transmitted through wireless communications. This makes it possible to broadcast (simultaneously transmit) a control on power modules connected to the power system. It is unnecessary to provide a facility that communicates with a controller for controlling a power module in a charging spot which is supplied with the power of the power system, and it is thus possible to suppress an increase in cost.

Each function shown in the above-mentioned embodiment may be implemented by one or more processing circuits. The processing circuits include a programmed processor, an electric circuit, and the like, and further also include a device such as an application-specific integrated circuit (ASIC), a circuit component arranged to execute a described function, and the like.

Although the content of the present invention has been described along with the embodiment, it is obvious to a person skilled in the art that the present invention is not limited to these descriptions, and various changes and modifications are possible. The discussions and drawings constituting part of this disclosure shall not be construed as limiting the present invention. Various alternative embodiments, examples, and operational techniques will be revealed to a person skilled in the art from this disclosure.

### REFERENCE SIGNS LIST

- 10: charging/discharging control device
- 15: receiver
- 21, 31: power supply device
- 23, 33: transmitter
- 50: power module
- 100: controller
- 110: voltage acquisition unit
- 120: calculation unit
- 130: determination unit
- 140: power determination unit

## Claims

1. A charging/discharging control method of controlling a power module (50) connected to any of a plurality of power systems, comprising:
- receiving (S101) a signal broadcast from each of the power systems via a receiver (15) included in the power module (50), wherein the signal is for adjusting supply power in each of the power systems;
- acquiring (S109) an input voltage input to the power module (50);
- calculating (S111) a predicted amount of change in power of the power module (50) for each of the power systems based on each of the signals from the power systems;
- calculating (S113) an amount of change in the input voltage;
- calculating (S115) a degree of relationship between the calculated predicted amount of change in the power and the calculated amount of change in the input voltage for each of the power systems; and
- controlling (S121) the power module (50) based on the signal relating to the power system having the degree of relationship greater than or equal to a prescribed threshold.

2. The method according to claim 1, comprising receiving (S101) the signal at at least two or more time points for each of the power systems (V1, ..., V4).

3. The method according to claim 1 or 2, comprising receiving (S101) the signal for a prescribed time period or more for each of the power systems (V1, ..., V4).

4. The method according to any one of the preceding claims, wherein:
- the signal relating to a first power system is a first signal,
- the signal relating to a second power system different from the first power system is a second signal, and
- the charging/discharging control method comprises, upon the predicted amount of change in the power calculated based on the first signal and the calculated amount of change in the input voltage have opposite signs and upon the predicted amount of change in the power calculated based on the second signal and the calculated amount of change in the input voltage have a same sign, calculating (S115) the degree of relationship such that the degree of relationship of the first power system becomes greater than the degree of relationship of the second power system.

5. The method according to any one of the preceding claims, wherein:
- the signal relating to a first power system is a first signal,
- the signal relating to a second power system different from the first power system is a second signal, and
- the charging/discharging control method comprises upon a degree of relationship calculated based on the first signal and a degree of relationship calculated based on the second signal being equal, recalculating the degrees of relationship based on the first signal and the second signal acquired after power of the power module (50) is changed.

6. The method according to any one of the preceding claims, wherein:
- the signal relating to a first power system is a first signal,
- the signal relating to a second power system different from the first power system is a second signal,
- an absolute value of a predicted amount of increase in power of the power module (50) based on the first signal is a first amount of increase,
- an absolute value of a predicted amount of increase in power of the power module (50) based on the second signal is a second amount of increase, and
- the charging/discharging control method comprises performing a control of increasing power of the power module (50) by a smaller amount of the first amount of increase and the second amount of increase.

7. The method according to any one of the preceding claims, wherein:
- the signal relating to a first power system is a first signal,
- the signal relating to a second power system different from the first power system is a second signal,
- an absolute value of a predicted amount of decrease in power of the power module (50) based on the first signal is a first amount of decrease,
- an absolute value of a predicted amount of decrease in power of the power module (50) based on the second signal is a second amount of decrease, and
- the method comprises performing a control of decreasing power of the power module (50) by a larger amount of the first amount of decrease and the second amount of decrease.

8. The method according to any one of the preceding claims, comprising calculating (S115) the degree of relationship based on the signal having an intensity greater than or equal to a prescribed intensity.

9. The method according to any one of the preceding claims, wherein the signal is transmitted through wireless communications.

10. A charging/discharging control device (10),
comprising:
- a controller (100) configured to control a power module (50) connected to any of a plurality of power systems; and
- a receiver (15),
wherein the controller (100) is configured:
- to receive (S101) a signal broadcast from each of the power systems via the receiver (15), wherein the signal is for adjusting supply power in each of the power systems;
- to acquire (S109) an input voltage input to the power module (50);
- to calculate (S111) a predicted amount of change in power of the power module (50) for each of the power systems based on each of the signals from the power systems;
- to calculate (S113) an amount of change in the input voltage;
- to calculate (S115) a degree of relationship between the calculated predicted amount of change in the power and the calculated amount of change in the input voltage for each of the power systems; and
- to control (S121) the power module (50) based on the signal relating to the power system having the degree of relationship greater than or equal to a prescribed threshold.

## Patentansprüche

1. Lade-/Entladesteuerverfahren zum Steuern eines Leistungsmoduls (50), das mit einem von mehreren Leistungssystemen verbunden ist, umfassend:
- Empfangen (S101) eines Signals, das von jedem der Leistungssysteme über einen in dem Leistungsmodul (50) enthaltenen Empfänger (15) rundgesendet wird, wobei das Signal zum Einstellen der Versorgungsleistung in jedem der Leistungssysteme dient;
- Erfassen (S109) einer Eingangsspannung, die in das Leistungsmodul (50) eingegeben wird;
- Berechnen (S111) eines vorhergesagten Änderungsbetrags der Leistung des Leistungsmoduls (50) für jedes der Leistungssysteme basierend auf jedem der Signale von den Leistungssystemen;
- Berechnen (S113) eines Änderungsbetrags der Eingangsspannung;
- Berechnen (S115) eines Grades der Beziehung zwischen dem berechneten vorhergesagten Änderungsbetrag der Leistung und dem berechneten Änderungsbetrag der Eingangsspannung für jedes der Leistungssysteme; und
- Steuern (S121) des Leistungsmoduls (50) basierend auf dem Signal, das sich auf das Leistungssystem bezieht, das den Grad der Beziehung aufweist, der größer oder gleich einem vorgeschriebenen Schwellenwert ist.

2. Verfahren nach Anspruch 1, umfassend das Empfangen (S101) des Signals zu mindestens zwei oder mehr Zeitpunkten für jedes der Leistungssysteme (V1, ..., V4).

3. Verfahren nach Anspruch 1 oder 2, umfassend das Empfangen (S101) des Signals für einen vorgeschriebenen Zeitraum oder mehr für jedes der Leistungssysteme (V1, ..., V4).

4. Verfahren nach einem der vorhergehenden Ansprüche, wobei:
- das Signal, das sich auf ein erstes Leistungssystem bezieht, ein erstes Signal ist,
- das Signal, das sich auf ein zweites Leistungssystem bezieht, das sich von dem ersten Leistungssystem unterscheidet, ein zweites Signal ist, und
- das Lade-/Entladesteuerverfahren, wenn der vorhergesagte Änderungsbetrag der Leistung, der basierend auf dem ersten Signal berechnet wird, und der berechnete Änderungsbetrag der Eingangsspannung entgegengesetzte Vorzeichen haben, und wenn der vorhergesagte Änderungsbetrag der Leistung, der basierend auf dem zweiten Signal berechnet wird, und der berechnete Änderungsbetrag der Eingangsspannung das gleiche Vorzeichen haben, das Berechnen (S115) des Grades der Beziehung umfasst, so dass der Grad der Beziehung des ersten Leistungssystems größer wird als der Grad der Beziehung des zweiten Leistungssystems.

5. Verfahren nach einem der vorhergehenden Ansprüche, wobei:
- das Signal, das sich auf ein erstes Leistungssystem bezieht, ein erstes Signal ist,
- das Signal, das sich auf ein zweites Leistungssystem bezieht, das sich von dem ersten Leistungssystem unterscheidet, ein zweites Signal ist, und
- das Lade-/Entladesteuerverfahren umfasst, dass, wenn ein Grad der Beziehung, der basierend auf dem ersten Signal berechnet wird, und ein Grad der Beziehung, der basierend auf dem zweiten Signal berechnet wird, gleich sind, die Grade der Beziehung basierend auf dem ersten Signal und dem zweiten Signal, die erfasst werden, nachdem die Leistung des Leistungsmoduls (50) geändert wird, neu berechnet werden.

6. Verfahren nach einem der vorhergehenden Ansprüche, wobei:
- das Signal, das sich auf ein erstes Leistungssystem bezieht, ein erstes Signal ist,
- das Signal, das sich auf ein zweites Leistungssystem bezieht, das sich von dem ersten Leistungssystem unterscheidet, ein zweites Signal ist,
- ein absoluter Wert eines vorhergesagten Erhöhungsbetrags der Leistung des Leistungsmoduls (50) basierend auf dem ersten Signal ein erster Erhöhungsbetrag ist,
- ein absoluter Wert eines vorhergesagten Erhöhungsbetrags der Leistung des Leistungsmoduls (50) basierend auf dem zweiten Signal ein zweiter Erhöhungsbetrag ist, und
- das Lade-/Entladesteuerverfahren das Durchführen einer Steuerung des Erhöhens der Leistung des Leistungsmoduls (50) um einen kleineren Betrag des ersten Erhöhungsbetrags und des zweiten Erhöhungsbetrags umfasst.

7. Verfahren nach einem der vorhergehenden Ansprüche, wobei:
- das Signal, das sich auf ein erstes Leistungssystem bezieht, ein erstes Signal ist,
- das Signal, das sich auf ein zweites Leistungssystem bezieht, das sich von dem ersten Leistungssystem unterscheidet, ein zweites Signal ist,
- ein absoluter Wert eines vorhergesagten Verringerungsbetrags der Leistung des Leistungsmoduls (50) basierend auf dem ersten Signal ein erster Verringerungsbetrag ist,
- ein absoluter Wert eines vorhergesagten Verringerungsbetrags der Leistung des Leistungsmoduls (50) basierend auf dem zweiten Signal ein zweiter Verringerungsbetrag ist, und
- das Verfahren das Durchführen einer Steuerung des Verringerns der Leistung des Leistungsmoduls (50) um einen größeren Betrag des ersten Verringerungsbetrags und des zweiten Verringerungsbetrags umfasst.

8. Verfahren nach einem der vorhergehenden Ansprüche, umfassend das Berechnen (S115) des Grades der Beziehung basierend auf dem Signal, das eine Intensität aufweist, die größer oder gleich einer vorgeschriebenen Intensität ist.

9. Verfahren nach einem der vorhergehenden Ansprüche, wobei das Signal durch drahtlose Kommunikation übertragen wird.

10. Lade-/Entladesteuervorrichtung (10),
umfassend:
- eine Steuerung (100), die konfiguriert ist, um ein Leistungsmodul (50) zu steuern, das mit einem von mehreren Leistungssystemen verbunden ist; und
- einen Empfänger (15),
wobei die Steuerung (100) konfiguriert ist:
- um ein Signal zu empfangen (S101), das von jedem der Leistungssysteme über den Empfänger (15) rundgesendet wird, wobei das Signal zum Einstellen der Versorgungsleistung in jedem der Leistungssysteme dient;
- um eine Eingangsspannung zu erfassen (S109), die in das Leistungsmodul (50) eingegeben wird;
- um einen vorhergesagten Änderungsbetrag der Leistung des Leistungsmoduls (50) für jedes der Leistungssysteme basierend auf jedem der Signale von den Leistungssystemen zu berechnen (S111);
- um einen Änderungsbetrag der Eingangsspannung zu berechnen (S113);
- um einen Grad der Beziehung zwischen dem berechneten vorhergesagten Änderungsbetrag der Leistung und dem berechneten Änderungsbetrag der Eingangsspannung für jedes der Leistungssysteme zu berechnen (S115); und
- um das Leistungsmodul (50) basierend auf dem Signal, das sich auf das Leistungssystem bezieht, das den Grad der Beziehung aufweist, der größer oder gleich einem vorgeschriebenen Schwellenwert ist, zu steuern (S121).

## Revendications

1. Procédé de commande de charge/décharge pour commander un module d'alimentation (50) connecté à l'un quelconque d'une pluralité de systèmes d'alimentation, comprenant :
- la réception (S101) d'un signal diffusé à partir de chacun des systèmes d'alimentation par l'intermédiaire d'un récepteur (15) inclus dans le module d'alimentation (50), dans lequel le signal est destiné à ajuster la puissance d'alimentation dans chacun des systèmes d'alimentation ;
- l'acquisition (S109) d'une tension d'entrée entrée dans le module d'alimentation (50) ;
- le calcul (S111) d'une quantité prédite de changement de puissance du module d'alimentation (50) pour chacun des systèmes d'alimentation sur la base de chacun des signaux provenant des systèmes d'alimentation ;
- le calcul (S113) d'une quantité de changement de la tension d'entrée ;
- le calcul (S115) d'un degré de relation entre la quantité prédite calculée de changement de la puissance et la quantité calculée de changement de la tension d'entrée pour chacun des systèmes d'alimentation ; et
- la commande (S121) du module d'alimentation (50) sur la base du signal relatif au système d'alimentation ayant le degré de relation supérieur ou égal à un seuil prescrit.

2. Procédé selon la revendication 1, comprenant la réception (S101) du signal à au moins deux points dans le temps ou plus pour chacun des systèmes d'alimentation (V1, ..., V4).

3. Procédé selon la revendication 1 ou 2, comprenant la réception (S101) du signal pendant une période de temps prescrite ou plus pour chacun des systèmes d'alimentation (V1, ..., V4).

4. Procédé selon l'une quelconque des revendications précédentes, dans lequel :
- le signal relatif à un premier système d'alimentation est un premier signal,
- le signal relatif à un second système d'alimentation différent du premier système d'alimentation est un second signal, et
- le procédé de commande de charge/décharge comprend, lorsque la quantité prédite de changement de l'alimentation calculée sur la base du premier signal et la quantité calculée de changement de la tension d'entrée ont des signes opposés et lorsque la quantité prédite de changement de l'alimentation calculée sur la base du second signal et la quantité calculée de changement de la tension d'entrée ont un même signe, le calcul (S115) du degré de relation de sorte que le degré de relation du premier système d'alimentation devienne supérieur au degré de relation du second système d'alimentation.

5. Procédé selon l'une quelconque des revendications précédentes, dans lequel :
- le signal relatif à un premier système d'alimentation est un premier signal,
- le signal relatif à un second système d'alimentation différent du premier système d'alimentation est un second signal, et
- le procédé de commande de charge/décharge comprend, lorsqu'un degré de relation calculé sur la base du premier signal et un degré de relation calculé sur la base du second signal sont égaux, le recalcul des degrés de relation sur la base du premier signal et du second signal acquis après que l'alimentation du module d'alimentation (50) a été changée.

6. Procédé selon l'une quelconque des revendications précédentes, dans lequel :
- le signal relatif à un premier système d'alimentation est un premier signal,
- le signal relatif à un second système d'alimentation différent du premier système d'alimentation est un second signal,
- une valeur absolue d'une quantité prédite d'augmentation de la puissance du module d'alimentation (50) sur la base du premier signal est une première quantité d'augmentation,
- une valeur absolue d'une quantité prédite d'augmentation de la puissance du module d'alimentation (50) sur la base du second signal est une seconde quantité d'augmentation, et
- le procédé de commande de charge/décharge comprend la réalisation d'une commande d'augmentation de la puissance du module d'alimentation (50) par une quantité plus petite de la première quantité d'augmentation et de la seconde quantité d'augmentation.

7. Procédé selon l'une quelconque des revendications précédentes, dans lequel :
- le signal relatif à un premier système d'alimentation est un premier signal,
- le signal relatif à un second système d'alimentation différent du premier système d'alimentation est un second signal,
- une valeur absolue d'une quantité prédite de diminution de la puissance du module d'alimentation (50) sur la base du premier signal est une première quantité de diminution,
- une valeur absolue d'une quantité prédite de diminution de la puissance du module d'alimentation (50) sur la base du second signal est une seconde quantité de diminution, et
- le procédé comprend la réalisation d'une commande de diminution de la puissance du module d'alimentation (50) par une quantité plus grande de la première quantité de diminution et de la seconde quantité de diminution.

8. Procédé selon l'une quelconque des revendications précédentes, comprenant le calcul (S115) du degré de relation sur la base du signal ayant une intensité supérieure ou égale à une intensité prescrite.

9. Procédé selon l'une quelconque des revendications précédentes, dans lequel le signal est transmis par l'intermédiaire de communications sans fil.

10. Dispositif de commande de charge/décharge (10),
comprenant :
- un dispositif de commande (100) configuré pour commander un module d'alimentation (50) connecté à l'un quelconque d'une pluralité de systèmes d'alimentation ; et
- un récepteur (15),
dans lequel le dispositif de commande (100) est configuré :
- pour recevoir (S101) un signal diffusé à partir de chacun des systèmes d'alimentation par l'intermédiaire du récepteur (15), dans lequel le signal est destiné à ajuster la puissance d'alimentation dans chacun des systèmes d'alimentation ;
- pour acquérir (S109) une tension d'entrée entrée dans le module d'alimentation (50) ;
- pour calculer (S111) une quantité prédite de changement de la puissance du module d'alimentation (50) pour chacun des systèmes d'alimentation sur la base de chacun des signaux provenant des systèmes d'alimentation ;
- pour calculer (S113) une quantité de changement de la tension d'entrée ;
- pour calculer (S115) un degré de relation entre la quantité prédite calculée de changement de la puissance et la quantité calculée de changement de la tension d'entrée pour chacun des systèmes d'alimentation ; et
- pour commander (S121) le module d'alimentation (50) sur la base du signal relatif au système d'alimentation ayant le degré de relation supérieur ou égal à un seuil prescrit.
